(19) Europäisches Patentamt

European Patent Office

Office européen des brevets

(11) **EP 1 207 627 B1**

(12) **EUROPEAN PATENT SPECIFICATION**

(45) Date of publication and mention
of the grant of the patent:
**19.01.2005 Bulletin 2005/03**

(51) Int Cl.⁷: **H04B 1/40**, H04B 1/30

(21) Application number: **00125017.4**

(22) Date of filing: **16.11.2000**

(54) **An efficient GS;/DSC/UMTS (UTRA/FDD) RF transceiver architecture**

Eine effiziente GSM/DCS/UMTS (UTRA/FDD) Sende-Empfänger-Architektur

Une architecture d'émetteur-récepteur radio efficace pour GSM/DCS/UMTS (UTRA/FDD)

(84) Designated Contracting States:
**DE FI FR GB**

(43) Date of publication of application:
**22.05.2002 Bulletin 2002/21**

(73) Proprietor: **Sony International (Europe) GmbH
10785 Berlin (DE)**

(72) Inventors:
• **Landing, Mikael,
c/o Sony Internat. (Europe) GmbH
70327 Stuttgart (DE)**

• **Rebmann, Jochen,
c/o Sony Internat. (Europe) GmbH
70327 Stuttgart (DE)**

(74) Representative: **Körber, Martin, Dipl.-Phys. et al
Mitscherlich & Partner
Patentanwälte
Sonnenstrasse 33
80331 München (DE)**

(56) References cited:
**EP-A- 0 653 851        WO-A-00/52840
WO-A-98/00927**

EP 1 207 627 B1

**Description**

The present invention relates generally to the architecture of transceivers in wireless communication devices for cellular networks operating at multiple carrier frequencies. In particular it relates to receivers and/or transmitters for use in third generation mobile phones and mobile communication devices adapted to operate at the three different frequency bands of the GSM, DCS, and UMTS (UTRA/FDD) systems.

The popularity of mobile phones has led to that not only business people required to be available at any time form the main clientele of the cellular network operators. With the increasing number of mobile phone subscribers the available frequency spectrum is stressed more and more, resulting in a diminished probability for finding a free channel when setting up a new connection. Furthermore, the cellular network is already set out for the next stage in its competition with the wired telephone services, by developing the technology for broad band services like wireless networking, fast internet access, and video conferencing. To make these new services possible, a new frequency band defined by the UMTS (UTRA/FDD) standard is currently made available for cellular telephone networks. Therefore, next generation mobile telephones have to facilitate communication on all of the three frequency bands available for cellular telephone networks in the near future.

Transceiver architectures for multiple frequency band transmission are already in use for mobile phones designed to operate on different transmission standards.

A dual frequency band transceiver architecture is known from US 5 878 332, using broad band components with a flat frequency response across both frequency bands together with narrow band components special for each of the two frequency bands.

A circuit arrangement, proposed in EP 0 653 851 B1 converts a first and a second frequency band to the same intermediate frequency by beating the respective frequency band against a local oscillator frequency band situated half way between the two frequency bands and deploying the high side injection method for the low frequency band and the low side injection method for the higher frequency band.

EP 0 878 917 A discloses a dual conversion superheterodyne, with the first stage downconverting the higher frequency band to an intermediate frequency of identical position as the second lower frequency band. Hereby, the second stage of the superheterodyne structure can be used as it is for the conversion of the lower frequency band, avoiding changes to the superheterodyne circuit while switching from one frequency band to the other.

A multiband-transceiver is disclosed in WO 00 52840 A1, which comprises a receiver portion and a transmitter portion, wherein the receiver portion includes a direct conversion system for directly downconverting a signal to baseband frequencies.

WO 98 00927 A1 reveals a dual band transceiver comprising a main VCO for generating a local oscillator (LO) signal, an offset VCO for generating an offset frequency (OF) signal and a first mixer for combining the LO signal with the OF signal to produce a transmit signal, which is then submitted to a modulator and to a second mixer for combining the first modulated signal with the LO signal to produce a second modulated signal.

The object of the present invention is now to propose an efficient receiver and transmitter circuit architecture for use in a triple band mobile communication device with a simple construction and a reduced number of components.

This object is achieved by a receive circuit arrangement operable at three frequency bands according to claim 1 and by a transmit circuit arrangement operable at three frequency bands according to claim 7.

The proposed architecture allows a simple and effective conversion of the signals by taking advantage of the superheterodyne and the direct conversion architecture, so that many components are shared for the signal conversion on the different frequency bands. The component sharing reduces the size of the transceiver circuitry, one of the main requirements for the design of modern mobile communication devices. The reduction in the number of components needed for the realisation of a triple band transceiver architecture further results in a more cost effective production.

Further advantageous features are claimed in the respective sub-claims.

Advantageously, the oscillation frequency band used in the receive mixing stage is selectively adapted for each of the three frequency bands. The receive mixing stage is further advantageously embedded in the receive section further comprising a means for to filter the signals received in any of the three frequency bands, and a means for converting signals received on the second or the third one of the three frequency bands from an in between modulation on an intermediate frequency further on to the base band. Further advantageously, the first frequency band corresponds to the UMTS (UTRA/FDD) frequency standard, the second frequency band corresponds to the DCS frequency standard, and the third frequency band corresponds to the GSM frequency standard.

In a further advantageous embodiment of the present invention, the oscillation frequency band used in the transmit mixing stage is selectively adapted for each of the three frequency bands, whereby the signals generated for further transmission on a second or on a third one of the frequency bands are particularly advantageous converted to the same intermediate frequency before being provided to the transmit mixing stage. The transmit section advantageously comprises a means for converting the signals to be transmitted on the second or the third frequency band to the intermediate frequency, the transmit mixing stage, and a means for to filter the transmit frequency band. In a particular advantageously embodiment of the present invention, the first frequency band is used according to the UMTS (UTRA/FDD), the second frequency band according to the DCS, and the third frequency band according to the GSM standard.

The receive and/or transmit arrangement according to the present invention can for example be implemented in the transceiving section of a cellular mobile phone but also in many communication devices like for example computer being wirelessly connected to a cellular network thus using the multiplicity of the new services offered with the introduction of the UMTS (UTRA/FDD) system.

In the following description, the present invention is explained in more detail in relation to the enclosed drawings, in which

Fig. 1   shows in a block diagram the basic processing steps carried out by the receive circuit arrangement according to the present invention,

Fig. 2   shows the basic processing steps carried out by the transmit circuit arrangement according to the present invention and

Fig. 3   is a circuit diagram of the receive circuit arrangement according to the present invention, and

Fig. 4   is a circuit diagram of the transmit circuit arrangement according to the present invention.

In the drawings like elements are assigned like reference numerals.

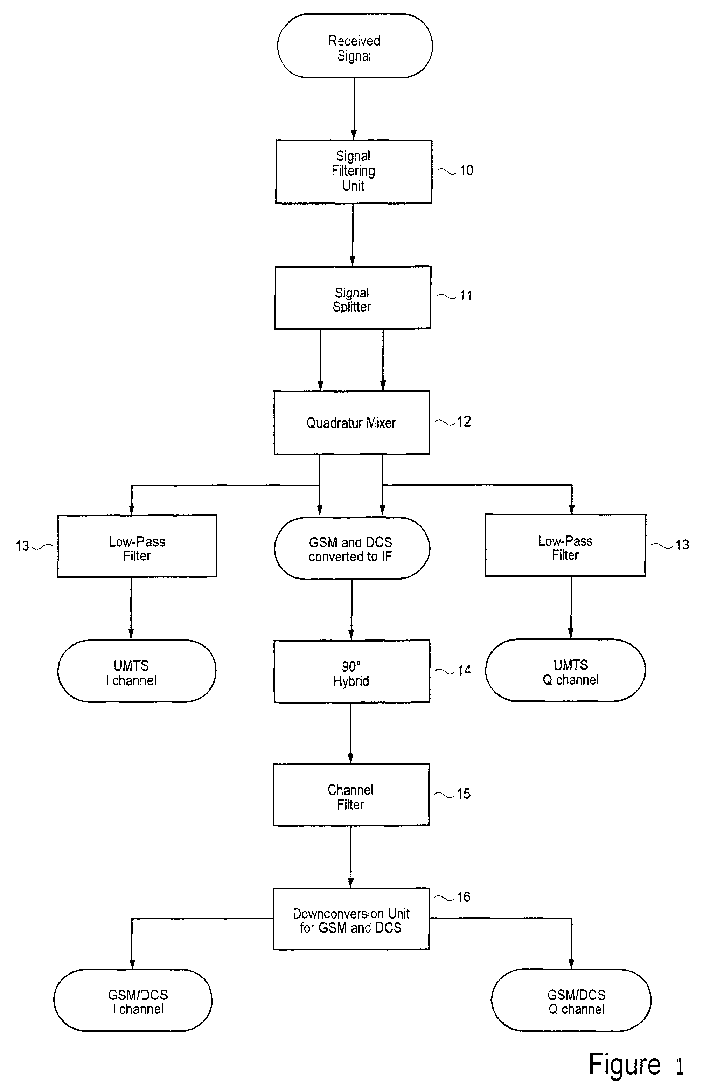

The flow chart of Fig. 1 demonstrates the signal processing carried out by the receive circuit arrangement operable at three frequency bands according to the present invention. It is to be understood that in the Figures only elements important for the understanding of the present invention are shown. Further elements, such as means for band control, the receiver front end, and means for base band processing are omitted for the sake of clarity.

Signals from the receiving front end are at first selectively filtered for the chosen frequency band by a filtering unit 10. For the separate conversion of the in-phase and in-quadrature component the signal has to be split up in two. This is carried out by a splitter 11 distributing the signals to two separate lines, whereby each of the resulting partial signal carries about half the power of the original signal. In the following quadrature mixer 12 according to the present invention, each of the split-up signals is mixed with an oscillation frequency band, whereby the oscillation frequency band used for the second one of the signals shows a 90° phase lead compared to first one. Signals received in the first one of the three frequency bands are hereby directly converted to the base band, whereby the in-phase channel is available at the output of the quadrature mixing station 12 where the oscillation frequency has been in phase with the carrier frequency of the received signal, and the in-quadrature channel is available at the output of the mixing section which processed the oscillation frequency with the 90° phase lead. Low band pass filters 13 at the output of the quadrature mixing station thereby block off other frequencies likewise created in the process of mixing the frequency bands.

For the other two frequency bands on which signals can be received, a signal is converted to an intermediate frequency band whereby the two signals provided at the outputs of the quadrature mixing stage 12 are identical except for a phase shift of 90°. The difference in the phase shift is corrected by the following 90°-hybrid, which also combines the two signals into one having a power of approximately the sum that of the primary signals. Before being converted down to the base band, with the in-phase and the in-quadrature channel available for further processing, the other frequencies originating from the quadrature mixing stage are blocked off by a band pass filter 15 adjusted to the intermediate frequency.

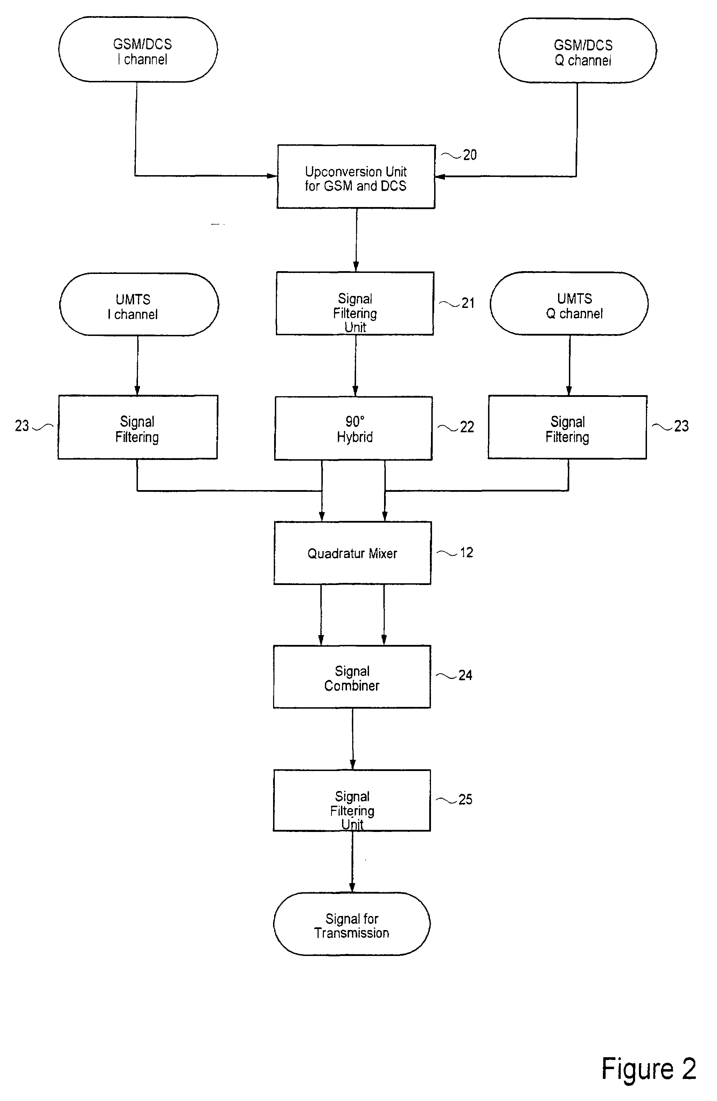

The in-phase and in-quadrature channels of the signal to be transmitted are, as shown in Fig. 2 either supplied to the low-pass filters 23 connected to the inputs of the quadrature mixing stage or are, if to be transmitted on one of the other two frequency bands supplied to the upconversion unit 20, which modulates the signals to the intermediate frequency. After passing the intermediate frequency filter, a 90°-hybrid 22 splits up the signal in two partial signals, one showing a relative phase shift of 90° like above. Each one of the partial signals is supplied to its appropriate input of the quadrature mixing stage 12. On this quadrature mixer 12, each signal channel to be transmitted on the first frequency band or each of the two partial signals on the intermediate frequency, respectively, is mixed with an oscillation frequency band, having a frequency position and bandwidth adapted for the transmission frequency band chosen. Taken from the outputs of the quadrature mixer 12, a combiner 24 transforms the two signals into one, which is then provided to the transmission amplifier after a final band pass filtering in the filtering unit 25 with the filter parameters appropriately selected for the chosen transmission frequency band.

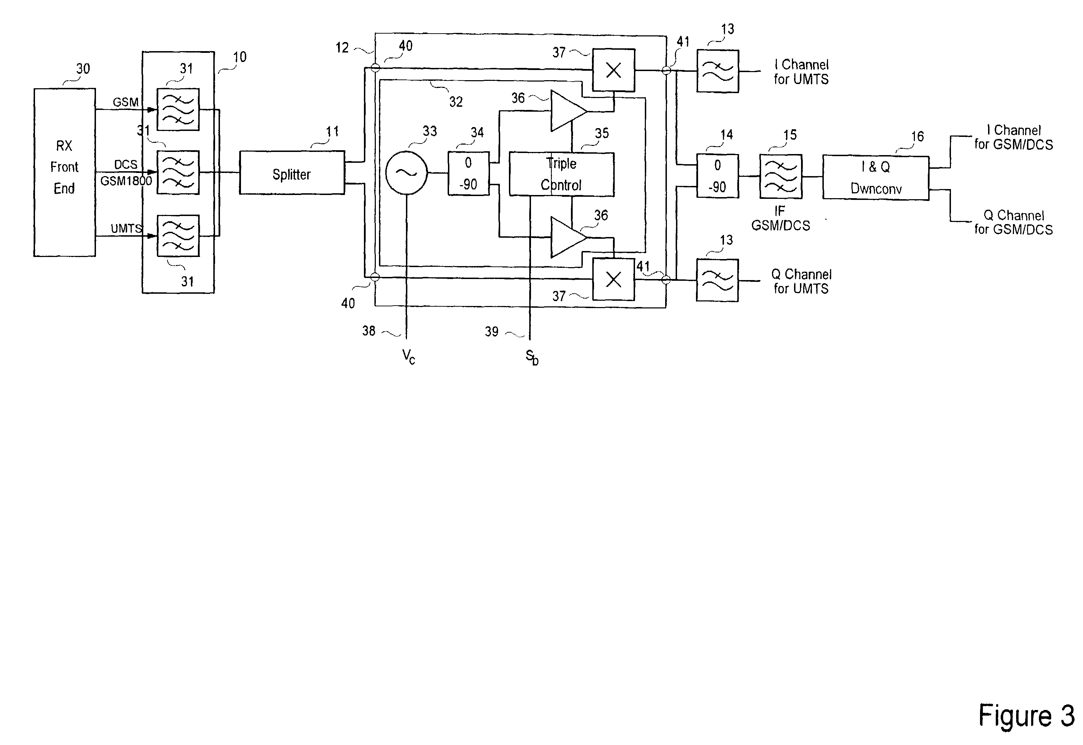

The circuit layout of the receiver according to the present invention is illustrated in Fig. 3. Signal received by the receiver front end 30 are distributed on three different lines, each one reserved for one of the respective frequency bands which can be selected by a separate circuitry not shown in the Figure. A band pass filter 31 adapted for the respective frequency band sieves out unwanted spectral components in each of the lines. For further signal processing two copies of the primary signal are needed. This is done by a splitter 11 distributing the signal onto two different lines, the signal on each of those lines carrying about half the power of the primary signal. Each signal is then fed to one of the inputs 40 of the quadrature mixer 12 according to the present invention. Signal processing in the quadrature mixing stage 12 is in principle done in two sections or branches, each containing a mixer 37 wherein the signal from the splitter 11 is mixed with the signal supplied from the local oscillator 32 thereby forming one or several combination frequency bands provided at the output of the mixer.

The local oscillator 32 according to the present invention is set up of three main components as illustrated e.g. in Fig. 3. A voltage controlled oscillator (VCO) 33, which can be controlled by an applied voltage produces an oscillation frequency band of variable bandwidth and variable centre frequency within a total range of at least 682.5 to 723.33 MHz. To extract the in-phase or the in-quadrature channel of a modulated signal the frequency of the local oscillator has to be in phase with the carrier frequency of the signal to be demodulated or show a 90° phase lead, respectively. Therefore, a 90°-hybrid 34 is used to split up the signal from the VCO in a first signal with identical frequency and phase relationship and a second signal with an identical frequency but a 90° phase lead in respect to the primary signal. Because the technical procedures for the in-phase are identical to that of the in-quadrature branch of the circuit, the further description restricts to the general principle of the signal processing, whereby it is understood that the signal processing has to be done in parallel and simultaneously for both sections of the circuit layout, although not always mentioned explicitly. In order to adapt the range of the VCO to the frequency position of the respective receive frequency band, a triple control unit 35 in conjunction with an amplifying stage 36 controls the harmonics of the VCO in such a way that depending on the momentarily selected receive frequency band either the fundamental or the third overtone of the VCO will be supplied to the mixer. A signal for selecting the appropriate mode of the local oscillator 32 comprising the voltage controlled oscillator 33, the 90°-hybrid 34, the triple control unit 35, and the amplifying stage 36 is provided by an extra circuit not shown in the figure.

In the following, the technical details for processing a signal received on the GSM band, stretching from 925 to 960 MHz are given. The VCO is set to produce an oscillating frequency band in the range of 682.5 to 717.5 MHz. The triple control is set to the fundamental oscillation of the voltage controlled oscillator. The mixer is operated in the low side injection mode. In other words, the difference between the GSM signal and the oscillation frequency band is present at the output of the mixer. Because the band width of the oscillation frequency is set to that of the received GSM signal, the received signal will be converted to an intermediate frequency of 242.5 MHz. Apart from this wanted frequency range (925 - 960 MHz), the mixer can likewise produce an 242.5 MHz intermediate frequency response for signals in the frequency range extending from 440 - 475 MHz. Due to the characteristic of the mixer this image frequency will be attenuated, so that filter with relaxed filter specifications can be used for further image rejection.

The two signals from the quadrature mixing stage output are combined in the following 90°-hybrid 14 and the resulting signal is then passed through an intermediate frequency band pass filter 15 with a centre frequency of 242.5 MHz. In a final stage 16, the signal is downconverted from the intermediate frequency to the base band and the in-phase and in-quadrature channel separated. Thus, the receiver structure for signals received on the GSM frequency band follows the superheterodyne principle, whereby the image rejecting filter specifications can be relaxed due to the image frequency attenuation properties of the quadrature mixer.

Likewise, the superheterodyne principle will be used to downconvert signals on the DCS frequency band ranging from 1805 to 1880 MHz. At first, signals supplied from the receiving front end are filtered selectively according the chosen frequency band by the appropriate RF reception filter 31 before being split up into two by the splitter unit 11 with each of the resulting partial signals being supplied to an RF port of a mixer 37 from the quadrature mixing stage 12. The oscillation frequency band of the voltage controlled oscillator 33 is set from 682.5 to 707.5 MHz. Like described above, the oscillation frequency signal is split up in two orthogonal signals but, because the mixing operation is identical for each of the two branches of the quadrature mixer, the process will be described only once, for it is understood that the operation is performed simultaneously and in parallel in both of the two mixing stage sections. In contrast to the conversion of the GSM signal, the triple control unit 35 is now set to yield the third overtone of the VCO frequency band. Thereby, a frequency band ranging from 2047.5 to 2122.5 MHz is supplied to the local oscillator port of the mixer. For converting the received DCS frequency band to the intermediate frequency, the high side injection mode is deployed. Hereby, the intermediate frequency $f_{IF}$ is obtained according the equation

$$f_{IF} = 3 \times f_{LO} - f_{DCS} \qquad (1),$$

whereby $f_{LO}$ describes the VCO frequency band and $f_{DCS}$ represents the received DCS signal.

Besides converting the DCS frequency band with the oscillation frequency band to an intermediate frequency, the mixer can also produce an 242.5 MHz intermediate frequency for signals in the frequency range extending from 2290 - 2365 MHz. Since the oscillation frequency band from the VCO and its phase are tripled, the quadrature mixer will also in this mode show a good attenuation of the image frequency, hereby reducing the requirements for the image rejection filter specifications like before in respect to the GSM signal conversion. Because a DCS signal is converted according to the present invention to the same intermediate frequency than a GSM signal, the further signal processing is done accordingly. That means, that also the conversion of a DCS signal follows the superheterodyne principle as it was employed for the conversion of signals on the GSM frequency band, whereby the mixer is operated in contrast hereto in the high side injection mode with the oscillation frequency band from the VCO tripled.

Signals received on the UMTS (UTRA/FDD) frequency band ranging from 2110 to 2170 MHz are at first filtered by an appropriate receive filter 31 and then split up by the splitter unit 11 in two independent partial signals each carrying about half the power of the primary signal, before being provided to the input ports 40 of in the in-phase and the in-quadrature branches of the quadrature mixing stage 12. The VCO 33 of the local oscillator 32 is set to an oscillation frequency band ranging from 703.33 to 723.33 MHz. The triple control unit is set on the third overtone of the VCO's oscillation frequency band so, that the local oscillator supplies a frequency band from 2110 to 2170 MHz to the local oscillator port of each mixer. Hereby, the local oscillation frequency band supplied to the mixer in the in-quadrature branch of the quadrature mixing stage shows a 90° phase lead compared to that supplied to the mixer in the in-phase branch of the quadrature mixing stage. Both frequency bands have the same position and bandwidth, therefore the resulting difference frequency is zero. In other words, signals received on the UMTS (UTRA/FDD) frequency band, are directly converted to the base band, whereby due to the above-described phase shift between the oscillation frequency bands supplied to the respective mixers of the in-phase and the in-quadrature branches of the quadrature mixer the in-phase channel and the in-quadrature channel of the baseband is provided at the respective output 41. Low-pass filters 13 clean the directly converted channels from spurious spectral components.

Although the necessary bandwidth of the oscillation frequency for converting the three frequency bands has to cover a range from 682.5 to 2170 MHz, the specifications for a voltage controlled oscillator producing an appropriate oscillation frequency have been limited to a frequency range from 682.5 to 723.33 MHz with the concept of the triple control unit. The tripling of the oscillation frequency can e.g. be done by switching the local oscillator buffers into a non-linear mode and making the output resonant on a third overtone.

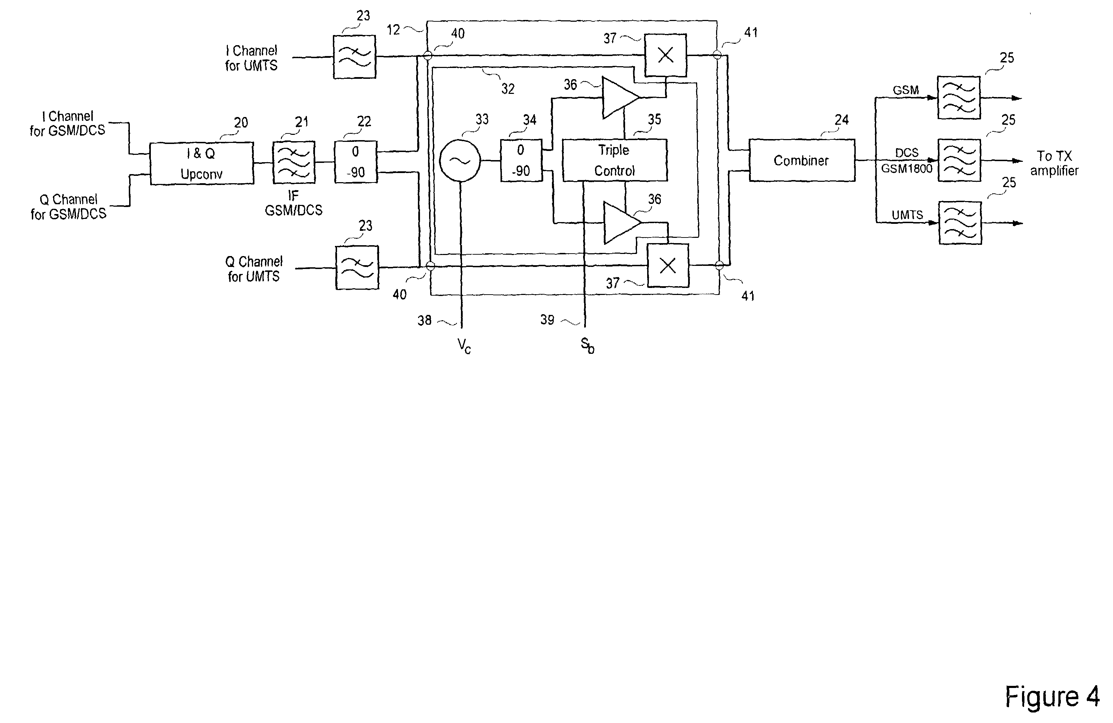

The scheme for transmitting a signal on one of the three frequency bands is laid out in Fig. 4. In the main, it reverses the receiver scheme described above. Signals generated for transmission on the GSM or DCS frequency band are at first upconverted to an intermediate frequency before undergoing further processing in the quadrature mixing stage according to the present invention, while signals generated for transmission on the UMTS (UTRA/FDD) frequency band are directly processed by the quadrature mixer.

Signals destined for transmission on the GSM or DCS frequency band are prepared the same way before getting heterodyned with an oscillation frequency. The upconversion unit 20 converts the in-phase and the in-quadrature channel to an intermediate frequency of 242.5 MHz. A subsequent band pass filter with a centre frequency of 242.5 MHz blocks off spurious spectral components produced in the upconversion process. Next, a 90°-hybrid splits up the signal in two partial signals of about half the original power, each one provided to the respective input 40 of the quadrature mixing stage 12. Signals destined for transmission in the UMTS (UTRA/FDD) frequency band are conditioned in the low-pass filters 23 and directly provided to the in-phase and in-quadrature input of the quadrature mixing stage, respectively. The frequency conversion in the quadrature mixing stage is done selectively appropriate for the selected frequency band and separately for each of the two orthogonal components which will be united into a single signal by the combiner 24, and then filtered according to the momentarily selected frequency band by a transmission filtering unit 25 before being handed over to the transmission amplifier.

For transmitting signals according to the GSM standard, the signals converted to the intermittent frequency have to be heterodyned with the local oscillator frequency band to a frequency band ranging from 880 to 915 MHz. According to that specification, the voltage controlled oscillator is operated in a frequency range from 637.5 to 672.5 MHz. The triple control of the local oscillator is set to the fundamental oscillation of the oscillation frequency band as supplied from the VCO. Like in the receiving unit of the transceiver according to the present invention, a signal from the voltage controlled oscillator is split up in a first partial signal with the same frequency and phase relationship and the second partial signal with the same frequency relationship but a 90° phase lead compared to the original signal. Thus the signals at the two outputs 41 of the quadrature mixture will be orthogonal to each other. The mixer 37 upconverts the signal from the intermediate frequency $f_{IF}$ according to the relation

$$f_{GSM} = f_{LO} + f_{IF} \qquad (2),$$

whereby $f_{GSM}$ defines the transmit frequency band and $f_{LO}$ the VCO frequency band.

In other words, the frequency band at the outputs of the quadrature mixer is the sum of the frequency band from the local oscillator with the intermediate frequency. The combiner 24 unites the orthogonal signals from the two outputs of the quadrature mixing stage and before the signal is forwarded to the transmitting amplifier it is filtered in the transmitting filter unit 25 to block off the image frequency, generated in the process of frequency mixing. The image frequency will already be attenuated thanks to the inherent properties of the quadrature mixer resulting in a reduced requirement for post filter specification.

Signal processing for transmission on the DCS frequency band ranging from 1710 to 1785 MHz is basically the same as for signals transmitted on the GSM frequency band. Apart from the fact, that the band pass specifications of the transmitting filter unit have to be set appropriately for the DCS band, the essential difference is the different operating mode of the local oscillator. The voltage controlled oscillator will be set to a frequency band from 650.83 to 675.83 MHz and the triple control unit will be adjusted for the third overtone of that frequency band. The 242.5 MHz intermediate frequency signal will be upconverted using the resulting frequency band of the local oscillator ranging from 1952.5 to 2027.5 MHz. Hereby, the mixers are operated in the low side injection mode according to the following relation

$$f_{DCS} = 3 \times f_{LO} - f_{IF} \qquad (3)$$

with the transmit frequency band $f_{DCS}$, the VCO frequency band $f_{LO}$, and the intermediate frequency band $f_{IF}$.

Again, the quadrature mixer will also suppress the image frequency in the operating mode of the frequency and phase from the voltage controlled oscillator tripled, allowing easier specifications for the post filtering of the signal and the transmitting filtering unit.

The processing conditions for a signal to be transmitted on the UMTS (UTRA/FDD) frequency band ranging from 1920 to 1980 MHz are quite different to the ones described above. Essentially, the first step of upconverting the in-phase and in-quadrature channel of the signal to an intermediate frequency is omitted. The signal is instead of this directly converted after a preceding separate low-pass filtering of the in-phase and in-quadrature channel. Each channel is mixed with an oscillation frequency of the same frequency band but with the oscillation frequency showing a 90° phase lead for the in-quadrature channel of the mixing stage. In order to be able to operate the voltage controlled oscillator in the same order of magnitude of its frequency range like for the other transmission frequency bands, the triple control of the local oscillator is set to the third harmonic of the oscillation frequency band as generated by the voltage controlled oscillator. Setting the frequency range of the VCO from 640 to 660 MHz thus results in a frequency range of the local oscillator from 1920 to 1980 MHz, which is identical to the frequency band used for the transmission of signals according to the UMTS (UTRA/FDD) standard. Because the primary signal is not yet modulated to any frequency, the conversion of the signal is done directly according to the equation

$$f_{UMTS} = 3 \times f_{LO} \qquad (4),$$

$f_{UMTS}$ representing the UMTS (UTRA/FDD) transmission frequency band and $f_{LO}$ the frequency band from the VCO.

The further processing of the two signals available in the output of the quadrature mixing stage correspond to that for the other two frequency bands with the exception that the band pass specifications of the transmitting filter have to be adapted for the UMTS (UTRA/FDD) specifications.

The triple control technology enables the use of straightforward narrowband VCOs, which only have to cover a range from 682.5 to 723.33 MHz in the receiving unit of the transceiver, and a range from 640 to 675.83 MHz in case of the transmitting section of the transceiver.

Because signals for the GSM and the DCS band are converted to and from the same intermediate frequency, no switching of or changes to the quadrature mixer are necessary when changing between the two frequency bands. The image rejection side will be correct in both cases without having to select different adjustments.

The ports of the mixer facing the intermediate frequency side of the quadrature mixing stage have to be optimised to work at 242.5 MHz and DC, respectively, while the RF port of every mixer has to be able to cover all three frequency bands. The local oscillator ports of the mixers further have to be optimised for the fundamental and the third overtone of the VCO oscillation frequency band.

Because the quadrature mixer output is used both for image rejection and the in-phase an in-quadrature base band output, the requirements for the specification of the subsequent filters are set very low.

**Claims**

1. A receive circuit arrangement operable at three frequency bands, comprising
   a receive mixing stage (12) for mixing a received signal with an oscillation frequency band for converting the received signal to a lower frequency band,
   whereby signals received on a first one of the three frequency bands are directly downconverted by said mixing stage,
   **characterised in,**
   **that** the receive mixing stage (12) downconverts signals received on a second and on a third one of the frequency bands to the same intermediate frequency band, and
   **that** said receive mixing stage comprises
   an oscillator means (33) for generating said oscillation frequency band, and

a control means (35) for controlling the harmonics of said oscillation frequency band such, that dependent on the selected first, second or third frequency band either the fundamental or the third overtone of said oscillation frequency band is used for downconverting the selected frequency band.

2. A receive circuit arrangement operable at three frequency bands according to claim 1, **characterised in,** **that** said oscillation frequency band used in said receive mixing stage is selectively adapted for each of the three frequency bands.

3. A receive circuit arrangement operable at three frequency bands according to claim 1 or 2, **characterised in,** **that** the receive section comprises a means (10) for filtering the signals received in the three frequency bands, and a means (16) for converting signals received on said second or said third frequency band from said intermediate frequency to the baseband.

4. A receive circuit arrangement operable at three frequency bands according to one of the claims 1 to 3, **characterised in,** **that** the first frequency band is the UMTS frequency band, and the second frequency band is the DCS frequency band, and the third frequency band is the GSM frequency band.

5. A transmit circuit arrangement operable at three frequency bands, comprising a transmit mixing stage (12) for mixing a signal generated for further transmission with an oscillation frequency band for upconverting the signal to the transmission frequency band, whereby for a first one of the three frequency bands said transmit mixing stage (12) converts the signals generated for further transmission directly from the baseband to the transmission frequency band, **characterised in,** **that** signals generated for further transmission on a second and on a third one of the frequency bands are upconverted by said transmit mixing stage (12) to the same intermediate frequency before being upconverted to the respective second or third frequency band, and **that** said transmit mixing stage (12) comprises an oscillator means (33) for generating said oscillation frequency band, and a control means (35) for controlling the harmonics of said oscillation frequency band such, that dependent on the selected first, second or third frequency band either the fundamental or the third overtone of said oscillation frequency is used for upconverting the signals to the intermediate frequency band and the first, second and third frequency bands.

6. A transmit circuit arrangement operable at three frequency bands according to claim 5, **characterised in,** **that** said oscillation frequency band used in said transmit mixing stage is selectivley adapted for each of the three frequency bands.

7. A transmit circuit arrangement operable at three frequency bands according to claims 5 or 6, **characterised in,** **that** the transmit section comprises a means (20) for converting the signals to be transmitted on said second or said third frequency band to said intermediate frequency, and said transmit mixing stage, and a means (25) for filtering the transmit frequency band.

8. A transmit circuit arrangement operable at three frequency bands according to one of the claims 5 to 7, **characterised in,** **that** the first frequency band is the UMTS frequency band, and the second frequency band is the DCS frequency band, and the third frequency band is the GSM frequency band.

## Patentansprüche

1. Empfangsschaltungsanordnung, die in drei Frequenzbändern betreibbar ist, welche aufweist:

eine Empfangsmischstufe (12), um ein Empfangssignal mit einem Schwingungsfrequenzband zu mischen, um das Empfangssignal in ein unteres Frequenzband umzusetzen, wodurch Signale, welche auf einem ersten der drei Frequenzbänder empfangen werden, unmittelbar durch die Mischstufe nach unten umgesetzt werden,

**dadurch gekennzeichnet, dass**
die Empfangsmischstufe (12) Signale, welche auf einem zweiten und einem dritten der Frequenzbänder empfangen werden, in das gleiche Zwischenfrequenzband umsetzt, und dass die Empfangsmischstufe aufweist

einen Oszillator (33), um das Schwingungsfrequenzband zu erzeugen, und

eine Steuerung (35), um die Oberwellen des Schwingungsfrequenzbands so zu steuern, dass in Abhängigkeit von dem ausgewählten ersten, zweiten oder dritten Frequenzband entweder die Grundschwingung oder die dritte Oberwelle des Schwingungsfrequenzbands zum Abwärtsumsetzen des ausgewählten Frequenzbands verwendet wird.

2. Empfangsschaltungsanordnung, die bei drei Frequenzbändern betreibbar ist, nach Anspruch 1,

> **dadurch gekennzeichnet, dass**
> das Schwingungsfrequenzband, welches in der Empfangsmischstufe verwendet wird, selektiv für jedes der drei Frequenzbänder angepasst ist.

3. Empfangsschaltungsanordnung, die mit drei Frequenzbändern betreibbar ist, nach Anspruch 1 oder 2,

> **dadurch gekennzeichnet, dass**
> der Empfangsabschnitt aufweist
> eine Einrichtung (10) zum Filtern der Signale, welche in den drei Frequenzbändern empfangen werden, und
> eine Einrichtung (16) zum Umsetzen von Signalen, welche im zweiten oder dritten Frequenzband empfangen werden, vom Zwischenfrequenzband in das Basisband.

4. Empfangsschaltungsanordnung, die bei drei Frequenzbändern betreibbar ist, gemäß einem der Ansprüche 1 bis 3,

> **dadurch gekennzeichnet, dass**
> das erste Frequenzband das UMTS-Frequenzband ist, und
> das zweite Frequenzband das DCS-Frequenzband ist, und
> das dritte Frequenzband das GSM-Frequenzband ist.

5. Sendeschaltungsanordnung, welche in drei Frequenzbändern betreibbar ist, welche eine Sendemischstufe (12) aufweist, um ein Signal, welches zur weiteren Sendung erzeugt wird, mit einem Schwingungsfrequenzband zu mischen, um das Signal in das Sendefrequenzband nach oben umzusetzen, wodurch

> für ein erstes der drei Frequenzbänder die Sendemischstufe (12) die Signale, die für weitere Sendung erzeugt werden, unmittelbar vom Basisband in das Sendefrequenzband umsetzt,
> **dadurch gekennzeichnet, dass**
> Signale, welche zur weiteren Sendung auf einem zweiten und auf einem dritten der Frequenzbänder erzeugt werden, durch die Sendemischstufe (12) auf die gleiche Zwischenfrequenz nach oben umgesetzt werden, bevor sie in das entsprechende zweite oder dritte Frequenzband nach oben umgesetzt werden, und
> dass die Sendemischstufe (12) aufweist:

einen Oszillator (33), um das Schwingungsfrequenzband zu erzeugen, und
eine Steuerung (35), um die Oberwellen des Schwingungsfrequenzbands so zu steuern, dass in Abhängigkeit von dem ausgewählten ersten, zweiten oder dritten Frequenzband entweder die Grundschwingung oder dritte Oberwelle der Schwingungsfrequenz dazu verwendet wird, um die Signale in das Zwischenfrequenzband und die ersten, zweite und dritten Frequenzbänder nach oben umzusetzen.

6. Sendeschaltungsanordnung, welche in drei Frequenzbändern betreibbar ist, nach Anspruch 5,

> **dadurch gekennzeichnet, dass**
> das Schwingungsfrequenzband, welches in der Sendemischstufe verwendet wird, selektiv für jedes der drei Frequenzbänder angepasst ist.

7. Empfangsschaltungsanordnung, welche in drei Frequenzbändern betreibbar ist, nach Anspruch 5 oder 6,

> **dadurch gekennzeichnet, dass**
> der Sendeabschnitt aufweist:

> eine Einrichtung (20), um die Signale, die auf dem zweiten oder dritten Frequenzband gesendet werden sollen, auf die Zwischenfrequenz umzusetzen, und
> die Sendemischstufe, und
> eine Einrichtung (25), um das Sendefrequenzband zu filtern.

8. Empfangsschaltungsanordnung, welche in drei Frequenzbändern betreibbar ist, nach einem der Ansprüche 5 oder 7,

> **dadurch gekennzeichnet, dass**
> das erste Frequenzband das UMTS-Frequenzband ist, und
> das zweite Frequenzband das DCS-Frequenzband ist, und
> das dritte Frequenzband das GSM-Frequenzband ist.

## Revendications

1. Agencement de circuit de réception pouvant fonctionner selon trois bandes de fréquence, comprenant un étage de mélange de réception (12) pour mélanger un signal de réception avec une bande de fréquence d'oscillation pour convertir le signal reçu selon une bande de fréquence inférieure, dans lequel les signaux reçus sur une première des trois bandes de fréquence sont directement convertis par abaissement par ledit étage de mélange ;

> **caractérisé en ce que** :

l'étage de mélange de réception (12) convertit par abaissement les signaux reçus sur une seconde et une troisième des bandes de fréquence à la même bande de fréquence intermédiaire ;

et **en ce que** ledit étage de mélange de réception comprend :

un moyen d'oscillateur (33) pour commander les harmoniques de ladite bande de fréquence d'oscillation de telle sorte que, en fonction de la bande de fréquence qui est sélectionnée parmi les première, seconde et troisième bandes de fréquence, soit la tonalité élevée fondamentale soit la troisième tonalité élevée de ladite bande de fréquence d'oscillation soit utilisée pour convertir par abaissement la bande de fréquence sélectionnée.

2. Agencement de circuit de réception pouvant fonctionner selon trois bandes de fréquence selon la revendication 1, **caractérisé en ce que** ladite bande de fréquence d'oscillation utilisée dans ledit étage de mélange de réception est adaptée de façon sélective pour chacune des trois bandes de fréquence.

3. Agencement de circuit de réception pouvant fonctionner selon trois bandes de fréquence selon la revendication 1 ou 2, **caractérisé en ce que** la section de réception comprend :

un moyen (10) pour filtrer les signaux reçus dans les trois bandes de fréquence ; et
un moyen (16) pour convertir les signaux reçus sur ladite seconde ou ladite troisième bande de fréquence depuis ladite fréquence intermédiaire jusqu'à la bande de base.

4. Agencement de circuit de réception pouvant fonctionner selon trois bandes de fréquence selon l'une des revendications 1 à 3, **caractérisé en ce que** la première bande de fréquence est la bande de fréquence UMTS, la seconde bande de fréquence est la bande de fréquence DCS et la troisième bande de fréquence est la bande de fréquence GSM.

5. Agencement de circuit d'émission pouvant fonctionner selon trois bandes de fréquence, comprenant un étage de mélange d'émission (12) pour mélanger un signal généré pour une émission supplémentaire avec une bande de fréquence d'oscillation pour convertir par élévation le signal selon la bande de fréquence d'émission, dans lequel, pour une première des trois bandes de fréquence, ledit étage de mélange d'émission (12) convertit les signaux générés pour une émission supplémentaire directement depuis la bande de base jusqu'à la bande de fréquence d'émission ;

**caractérisé en ce que** :

des signaux générés pour une émission supplémentaire sur une seconde et une troisième des! bandes de fréquence sont convertis par élévation par ledit étage de mélange d'émission (12) à la même bande de fréquence intermédiaire avant d'être convertis par élévation à la seconde ou troisième bande de fréquence respective;

et **en ce que** ledit étage de mélange de d'émission (12) comprend :

un moyen d'oscillateur (33) pour générer ladite bande de fréquence d'oscillation ; et un moyen de commande (35) pour commander les harmoniques de ladite bande de fréquence d'oscillation de telle sorte que, en fonction de la bande de fréquence qui est sélectionnée parmi les première, seconde et troisième bandes de fréquence, soit la tonalité élevée fondamentale soit la troisième tonalité élevée de ladite fréquence d'oscillation soit utilisée pour convertir par élévation les signaux selon la bande de fréquence intermidiaire et selon les première, seconde et troisième bandes de fréquence.

6. Agencement de circuit d'émission pouvant fonctionner selon trois bandes de fréquence selon la revendication 5, **caractérisée en ce que** ladite bande de fréquence d'oscillation utilisée dans ledit étage de mélange d'émission est adaptée de façon sélective pour chacune des trois bandes de fréquence.

7. Agencement de circuit d'émission pouvant fonctionner selon trois bandes de fréquence selon la revendication 5 ou 6, **caractérisé en ce que** la section d'émission comprend :

un moyen (20) pour convertir les signaux à émettre sur ladite seconde ou troisième bande de fréquence dans ladite fréquence intermédiaire et dans ledit étage de mélange d'émission ; et
un moyen (25) pour filtrer la bande de fréquence d'émission.

8. Agencement de circuit d'émission pouvant fonctionner selon trois bandes de fréquence selon l'une des revendications 5 à 7, **caractérisé en ce que** la première bande de fréquence est la bande de fréquence UMTS, la seconde bande de fréquence est la bande de fréquence DCS et la troisième bande de fréquence est la bande de fréquence GSM.

Figure 1

GSM/DCS
I channel

GSM/DCS
Q channel

Upconversion Unit
for GSM and DCS ～20

UMTS
I channel

Signal
Filtering
Unit ～21

UMTS
Q channel

23～ Signal
Filtering

90°
Hybrid ～22

Signal
Filtering ～23

Quadratur Mixer ～12

Signal
Combiner ～24

Signal
Filtering
Unit ～25

Signal for
Transmission

Figure 2

Figure 3

EP 1 207 627 B1

Figure 4